**Europäisches Patentamt**

**European Patent Office**

**Office européen des brevets**

(19)

(11) Numéro de publication: **0 053 531**
**B1**

(12)

# FASCICULE DE BREVET EUROPEEN

(45) Date de publication du fascicule du brevet:
22.08.84

(51) Int. Cl.³: **H 02 G 5/00**

(21) Numéro de dépôt: 81401783.6

(22) Date de dépôt: 10.11.81

(54) Barre d'alimentation comportant un empilement de 2 N couches diélectriques disposées en alternance avec 2N couches métalliques.

(30) Priorité: 28.11.80 FR 8025270

(43) Date de publication de la demande:
09.06.82 Bulletin 82/23

(45) Mention de la délivrance du brevet:
22.08.84 Bulletin 84/34

(84) Etats contractants désignés:
DE

(56) Documents cités:
US - A - 3 312 870
US - A - 3 520 987

(73) Titulaire: **L.C.C.-C.I.C.E. - COMPAGNIE EUROPEENNE DE COMPOSANTS ELECTRONIQUES, 101, Boulevard Murat, F-75781 Paris Cedex 16 (FR)**

(72) Inventeur: **Fleuret, Daniel, THOMSON-CSF SCPI 173, bld Haussmann, F-75360 Paris cedex 08 (FR)**

(74) Mandataire: **Vesin, Jacques et al, THOMSON-CSF SCPI 173, Bld Haussmann, F-75379 Paris Cedex 08 (FR)**

ACTORUM AG

## Description

La présente invention concerne des barres d'alimentation de faible impédance caractéristique pour la transmission d'un signal électrique d'une source à une pluralité de récepteurs, ladite barre d'alimentation comportant notamment deux barres conductrices véhiculant le courant par des moyens diélectriques. Un exemple d'une telle barre d'alimentation est décrit dans le brevet américain US-A N° 3520987.

De telles barres d'alimentation, connues également sous l'appellation anglo-saxonne de bus-bar, sont utilisées depuis fort longtemps, notamment dans les systèmes d'alimentation des circuits électriques d'ordinateur.

De telles lignes d'alimentation ont été réalisées dans le passé pour se substituer aux câbles coaxiaux beaucoup trop encombrants dans les circuits miniaturisés. Afin de réaliser le découplage nécessaire entre les différents circuits d'utilisation, il a déjà été proposé de connecter des capacités en parallèle sur la ligne afin d'augmenter le découplage.

Toutefois, le montage de ces capacités en parallèle sur la ligne rend très difficiles les opérations de maintenance de celle-ci, ainsi que les problèmes de montage.

Il a été proposé dans le brevet américain US-A N° 3189847 d'utiliser des barres d'alimentation constituées de deux barres conductrices séparées par un diélectrique dont les pertes augmentent avec la fréquence, tel qu'un matériau ferromagnétique qui a la propriété d'être conducteur aux basses fréquences, ou en courant continu, mais qui atténue très rapidement tous les signaux hautes fréquences. De cette façon, on évite la propagation sur la barre d'alimentation de signaux impulsionnels de fréquence élevée qui pourraient perturber le fonctionnement des circuits connectés sur ladite barre d'alimentation.

Toutefois, un tel système présente l'inconvénient d'utiliser un matériau très particulier, relativement coûteux et possédant de mauvaises propriétés mécaniques. En effet, un tel matériau ferromagnétique est généralement cassant, et les barres d'alimentation obtenues selon la technique décrite dans ce brevet sont des barres rigides et d'épaisseur relativement importante. De plus, la transmission des signaux hautes fréquences avec une telle barre est impossible, compte tenu de la conception de celle-ci. Plus récemment, il a été proposé dans le brevet américain US-A N° 3312870 de réaliser ces barres d'alimentation à l'aide de deux barres conductrices séparées par un matériau diélectrique ayant une constante diélectrique très élevée. Le matériau à haute constante diélectrique est obtenu à l'aide d'un empilement de plaques métalliques revêtues d'un film isolant d'oxyde obtenu par anodisation, les plaques étant assemblées les unes aux autres à l'aide d'une couche adhésive. Un tel dispositif est cependant peu facile à réaliser du fait de l'anodisation nécessaire des plaques métalliques et de leur épaisseur relativement importante, ce qui, pour des capacités élevées, conduirait à une épaisseur totale des barres d'alimentation inacceptable.

Plus récemment, il a été proposé dans le brevet français FR-A N° 2438933 d'utiliser non pas simplement un film diélectrique adhésif interposé entre les deux barres d'alimentation, mais de remplacer ledit film diélectrique adhésif par des pastilles successives de céramique à haute constante diélectrique. Une solution tout à fait identique avait d'ailleurs déjà été proposée par la titulaire dans le brevet américain US-A N° 3778735. L'utilisation de matériau céramique à haute constante diélectrique présente cependant l'inconvénient d'introduire des pertes diélectriques et, par conséquent, une résistance série qui, aux fréquences élevées, dégrade l'impédance caractéristique des lignes ainsi réalisées et n'assure donc pas une bonne transmission de l'information.

Tous les systèmes connus proposés jusqu'à ce jour, tels que ceux décrits ci-dessus, présentent cependant divers inconvénients: il existe en effet deux problèmes à résoudre lorsqu'on veut réaliser des barres d'alimentation à faible impédance caractéristique et sans pertes aux hautes fréquences. Ces barres doivent avoir la capacité répartie la plus forte possible afin d'obtenir une très faible impédance caractéristique, et doivent posséder une épaisseur aussi réduite que possible afin de prendre le minimum de place dans les circuits utilisant ces barres d'alimentation.

Lorsqu'on veut alimenter par exemple quelques circuits intégrés disposés sur un circuit imprimé, la barre d'alimentation ne doit bien entendu pas avoir une largeur excessive comparée à la largeur des boîtiers desdits circuits intégrés. Or, si l'on veut réaliser des barres d'alimentation ayant une très forte capacité, on peut soit réaliser des barres de grande largeur avec une seule couche de film diélectrique très mince interposé entre les barres d'alimentation, soit réaliser une barre de la façon décrite dans le brevet américain US-A N° 3312870.

Dans le premier cas, lesdites barres d'alimentation sont trop encombrantes et trop fragiles. En effet, les barres conductrices, généralement métalliques, ont un état de surface assez approximatif, c'est-à-dire qu'il existe par endroit des parties saillantes métalliques de quelques microns d'épaisseur. Lorsqu'on assemble les deux barres conductrices à l'aide du film diélectrique adhésif, ces parties saillantes percent ledit diélectrique et la barre est en court-circuit.

Dans le second cas, les barres d'alimentation ainsi réalisées ont une épaisseur trop importante pour être utilisées dans certaines applications, notamment lorsqu'on veut placer lesdites barres sous les boîtiers des circuits intégrés du type DIL, entre les pattes desdits circuits intégrés.

Par conséquent, il n'existe pas à l'heure actuelle de barres d'alimentation possédant une certaine souplesse, une impédance caractéristique très faible et une épaisseur réduite.

Les barres d'alimentation selon l'invention ne possèdent pas les inconvénients des barres d'alimentation décrites ci-dessus et répondent au problème posé.

Dans ce but, les barres d'alimentation selon l'invention sont caractérisées en ce que lesdits moyens diélectriques sont constitués par un empilement de films diélectriques métallisés formant un ensemble de 2 n films diélectriques, identiques ou différents, disposés en alternance avec 2 n couches métalliques, les couches métalliques de rangs pair et impair étant respectivement reliées entre elles latéralement par des connexions électriques, les barres conductrices étant fixées de part et d'autre de l'empilement et reliées électriquement, respectivement, à l'une des connexions électriques latérales. Les films métallisés peuvent être recouverts de métal sur l'une ou les deux faces. Dans ce dernier cas, on retrouvera dans l'empilement des couches métalliques constituées par deux couches superposées qui seront donc reliées électriquement entre elles par contact.

De préférence, on interposera entre l'empilement et chacune des barres conductrices des moyens formant coussin, dont le but est d'éviter avant tout une détérioration des couches de l'empilement. De préférence, l'épaisseur desdits coussins sera supérieure ou égale à 10 μm. Ces coussins pourront être constitués soit d'un adhésif tel qu'une colle époxy, un isocyanate, un polyuréthanne ou un mélange de ceux-ci avec leurs durcisseurs respectifs (colles à un ou deux composants), cet adhésif étant isolant ou conducteur, soit d'une couche électriquement inactive, formée d'un film diélectrique souple.

Les moyens formant coussin peuvent remplir la double fonction, d'une part, de permettre l'assemblage entre l'empilement de films diélectriques et les barres conductrices et, d'autre part, d'éviter un contact direct entre les films métallisés et lesdites barres conductrices, afin d'éviter les blessures mécaniques de l'un par l'autre. Dans ce but, on utilisera de préférence un adhésif qui, suivant les cas, par exemple suivant la forme de la barre d'alimentation réalisée, sera isolant ou conducteur.

Comme adhésif conducteur, on pourra utiliser soit des vernis conducteurs, soit des colles conductrices. La nature conductrice de ces vernis ou colles est généralement donnée par la présence d'une poudre métallique en quantité assez importante dans ceux-ci. Généralement, la poudre métallique est de l'argent, connu pour ses très bonnes propriétés conductrices.

Concernant les colles isolantes, on pourra utiliser tous types de colles à un ou deux composants bien connues de l'homme de l'art. En particulier, on pourra utiliser les colles du type polyuréthanne et/ou époxy.

Dans le cas où les moyens formant coussin sont constitués par une couche électriquement inactive, formée d'un film diélectrique souple, celui-ci pourra être identique ou différent de l'un des diélectriques de l'empilement. Il sera de préférence choisi dans la même famille, décrite ci-après. Ce film sera rendu solidaire de l'empilement soit à l'aide d'un adhésif, soit à l'aide des connexions électriques latérales: celles-ci étant généralement obtenues par projection de métal en fusion, le film diélectrique est ainsi englobé dans l'empilement par le métal projeté.

La partie supérieure de ce film sera rendue solidaire des barres conductrices, généralement à l'aide d'un adhésif tel que défini ci-dessus.

D'une façon générale, et si l'on désire rendre la barre d'alimentation selon l'invention plus rigide, on pourra introduire dans l'empilement m couches d'adhésifs, disposées entre les 2 n couches de films métallisés, m étant inférieur ou égal à 2 n −1. Suivant le résultat désiré, on pourra faire varier m de 1 à 2 n −1. L'épaisseur de l'adhésif, choisi de préférence parmi les adhésifs courants disponibles dans le commerce, tels que décrits ci-dessus, variera généralement entre 0,2 et 2 μm.

De telles barres d'alimentation présentent des avantages importants par rapport aux barres d'alimentation connues, y compris celles comportant deux barres conductrices séparées par un film diélectrique adhésif. En effet, les barres d'alimentation selon l'invention possèdent la propriété d'être autocicatrisables.

Le phénomène d'autocicatrisation est le suivant: lorsque le film diélectrique possède des défauts, encore appelés points conducteurs, la mise sous tension de la barre conductrice, c'est-à-dire l'apparition d'une différence de potentiel entre les deux barres conductrices, provoque la volatilisation des parties d'armature métallisée en regard du point conducteur, sans perforation du diélectrique. De cette façon, la barre d'alimentation est malgré tout utilisable, aucun court-circuit n'apparaissant entre les barres conductrices.

Au contraire, dans le cas où l'on utilise en diélectrique, adhésif ou non, entre deux barres conductrices jouant le rôle d'armatures comme cela est décrit dans l'art antérieur, lorsque le diélectrique présente un défaut, on constate qu'à la mise sous tension de la barre il y a perforation du diélectrique aux endroits correspondant aux points conducteurs lorsque la tension devient assez élevée: il y a alors court-circuit de ladite barre d'alimentation. Les barres d'alimentation selon l'invention possèdent donc le très grand avantage d'une fiabilité accrue par rapport aux barres d'alimentation du même type connues jusqu'à ce jour.

De plus, les films métallisés utilisés pour réaliser les barres selon l'invention permettant à ladite barre de subir un gradient de tension élevée, le diélectrique utilisé peut avoir une épaisseur faible, ce qui se traduit par une augmentation importante de la capacité, c'est-à-dire que la barre d'alimentation selon l'invention possède une impédance caractéristique très faible. On peut en effet, dans le cadre de l'invention, utiliser des films diélectriques d'épaisseur de l'ordre de 1,5 μm, tout en ayant une tension de service supérieure à 100 V.

Au contraire, dans le cas d'armatures solides, le film diélectrique doit avoir une épaisseur d'au moins 20 μm pour que la barre d'alimentation possède une fiabilité d'utilisation correcte. Dans ces conditions, la capacité par unité de longueur de ladite barre est bien évidemment beaucoup plus faible, ce qui se traduit par une impédance caractéristique beaucoup plus élevée et par une barre d'alimentation mal adaptée au problème à résoudre.

L'impédance caractéristique des barres selon l'invention reste faible même aux très hautes fréquences, contrairement à celles faisant usage d'un matériau céramique à forte constante diélectrique. En effet, dans le cas d'un matériau céramique, les pertes diélectriques en haute fréquence introduisent une résistance série dans le circuit qui dégrade l'impédance caractéristique des lignes ainsi réalisées.

De plus, contrairement aux barres connues de l'art antérieur, les barres d'alimentation selon l'invention peuvent être coupées à la longueur voulue sans aucun risque de court-circuit entre les barres conductrices. En effet, la présence des coussins permet une séparation suffisante des barres entre elles.

Les barres métalliques selon l'invention peuvent être utilisées, ainsi que cela sera décrit par la suite, soit verticalement, c'est-à-dire disposées entre les circuits intégrés de la carte imprimée, soit horizontalement, c'est-à-dire sous les circuits intégrés entre leurs pattes de connexion.

Lorsqu'on utilise ces barres d'alimentation verticalement, les barres conductrices ont leur connexions destinées à être fixées dans les trous des circuits imprimés situées du même côté d'une connexion électrique latérale. Dans ce but, lesdites barres conductrices seront donc fixées de part et d'autre de l'empilement de films diélectriques métallisés à l'aide de deux adhésifs différents, la partie de la barre conductrice située à proximité de la connexion électrique latérale à laquelle elle doit être reliée étant fixée à l'aide d'un adhésif conducteur de l'électricité, tandis que l'autre partie de la barre conductrice, située en regard de la connexion électrique à laquelle elle ne doit pas être reliée, sera fixée à l'aide d'un adhésif ou d'un film adhésivé non conducteur de l'électricité.

De préférence, afin de renforcer la résistance mécanique desdites barres d'alimentation, on disposera également de l'adhésif, conducteur ou non conducteur, à l'intérieur des dièdres rentrants formés par les barres d'alimentation et les connexions électriques latérales reliant entre eux les films métallisés. Cela est particulièrement nécessaire à l'intérieur des dièdres situés du côté où la barre conductrice doit être connectée sur le circuit imprimé.

Comme film diélectrique utilisable dans le cadre de l'invention, on pourra utiliser tout film diélectrique ayant des propriétés convenables, bien connues de l'homme de l'art. De préférence, on utilisera les films diélectriques courants tels que le papier, les polyoléfines, et en particulier le polypropylène et le polyéthylène, le polycarbonate, le polysulfone, le polystyrène, ou les polyesters tels que le polytéréphtalate d'éthylène, ceux-ci étant généralement les films préférés dans le cadre de la présente invention (en particulier à cause de leur forte constante diélectrique). On peut également utiliser d'autres films diélectriques tels que les films de polyamide (Nylon 6, Nylon 6,6, ...), polyimide, polyamide-imide, polytétrafluoroéthylène, polyfluorure de vinylidène, etc. L'épaisseur du film utilisé sera aussi faible que possible, puisque la capacité de la barre augmente lorsque l'épaisseur du diélectrique diminue. Celle-ci sera généralement inférieure à 20 μm, et de préférence inférieure à 5 μm. On choisira de préférence un diélectrique ayant un angle de perte à 25° C, à la fréquence de 1 kHz, tel que la tangente de cet angle, appelée couramment tangente δ, soit dans tous les cas inférieure ou égale à $2 \times 10^{-2}$, et de préférence inférieure à $5 \times 10^{-3}$.

D'une manière générale, on choisira le type de diélectrique, son épaisseur, etc., de telle manière que l'on obtienne une capacité par centimètre de longueur de barres d'alimentation supérieure à 20 nF. On considère en effet que cette valeur est une valeur minimale pour obtenir des barres d'alimentation à faible constante répartie permettant de transmettre tous les signaux, du continu jusqu'à plusieurs centaines de MHz. C'est ce qui rend la réalisation de ces barres d'alimentation particulièrement délicate.

Le métal utilisable pour métalliser la surface du film diélectrique sera de préférence le zinc, l'aluminium, l'argent, l'or ou le cuivre. L'épaisseur de la couche métallique déposée sur le film diélectrique sera telle que la résistance carrée du film métallisé varie entre 0,5 et 5 Ω. Par résistance carrée, on entend la résistance de la couche métallique d'un carré de film métallisé de, par exemple, 1 cm de côté.

En effet, au-delà d'une résistance carrée de 5 Ω, on constate que le dépôt métallique est si mince qu'il se produit des inégalités dans la répartition du métal, lesdites inégalités engendrant des défauts importants dans les barres d'alimentation obtenues avec ces films. Pour une résistance carrée inférieure à 0,5 Ω, on considère généralement que l'épaisseur du dépôt métallique est trop importante pour rendre économiquement intéressante la réalisation de barres d'alimentation par ces procédés. De plus, un dépôt épais est difficile à réaliser et la barre d'alimentation obtenue avec un dépôt épais perd sa faculté d'autocicatrisation.

Les barres conductrices seront généralement réalisées en matériau très conducteur, tel que le cuivre. De préférence, ce matériau conducteur sera recouvert d'une couche d'étain, déposée avant ou après découpe desdites barres. Cet étamage sera réalisé, de manière connue en soi, soit par voie chimique, soit par voie électrolytique. L'épaisseur de la couche d'étain sera de préférence de 20 μm. Lorsque cet étamage est réalisé avant découpe des barres, on constate que la couche d'étain subit un fluage au cours de la découpe et vient ainsi protéger le bord latéral de la barre conductrice.

En pratique, on réalisera généralement des barres d'alimentation comportant entre quatre et vingt couches de film diélectrique métallisé, les autres éléments de la barre étant choisis de telle sorte que l'épaisseur totale de celle-ci reste inférieure à 3 mm. Ces données correspondent au meilleur mode de réalisation de l'invention.

Pour réaliser les barrres d'alimentation selon l'invention, on réalise tout d'abord l'empilement des films diélectriques métallisés et leur assemblage par projection latérale de métal. Cette technique est en elle-même bien connue et décrite, par exemple, dans le brevet français FR-A N° 903040. Les empilements ainsi réalisés sont ensuite découpés à la longueur voulue et assemblés avec les barres conductrices correspondantes. Celles-ci peuvent se présenter sous forme de rouleaux qui sont déroulés au cours de l'assemblage avec les empilements diélectriques, chaque barre étant au préalable revêtue d'une couche de colle aux endroits voulus, par exemple à l'aide d'un tambour muni d'un écran de soie qui permet le dépôt en continu de la colle par sérigraphie. Afin d'obtenir les viscosités nécessaires à l'utilisation du procédé de la sérigraphie, on ajustera la viscosité des colles utilisées par dilution plus ou moins importante dans un solvant approprié. Après assemblage sous pression des empilements et des barres pendant un intervalle de temps suffisant pour permettre à la colle de polymériser, les barres d'alimentation selon l'invention sont prêtes à l'emploi.

On peut cependant, si cela est nécessaire, procéder à un enrobage dans une résine appropriée des barres ainsi réalisées. Cette protection peut être également une peinture, un ruban thermoplastique ou adhésif, etc.

L'invention sera mieux comprise à l'aide des exemples de réalisation suivants, donnés à titre non limitatif, conjointement avec les figures.

La fig. 1 représente une première variante de réalisation des barres d'alimentation selon l'invention, correspondant à une position verticale de la barre;

la fig. 2 représente une vue d'ensemble de la barre d'alimentation de la fig. 1 ;

la fig. 3 représente une deuxième variante de réalisation de l'invention, correspondant à une position horizontale de la barre;

la fig. 4 est une vue d'ensemble d'une barre selon la fig. 3, et

la fig. 5 représente un exemple d'utilisation d'une barre telle que décrite sur les fig. 3 et 4, implantée sur un circuit imprimé entre les pattes de connexion de circuits intégrés.

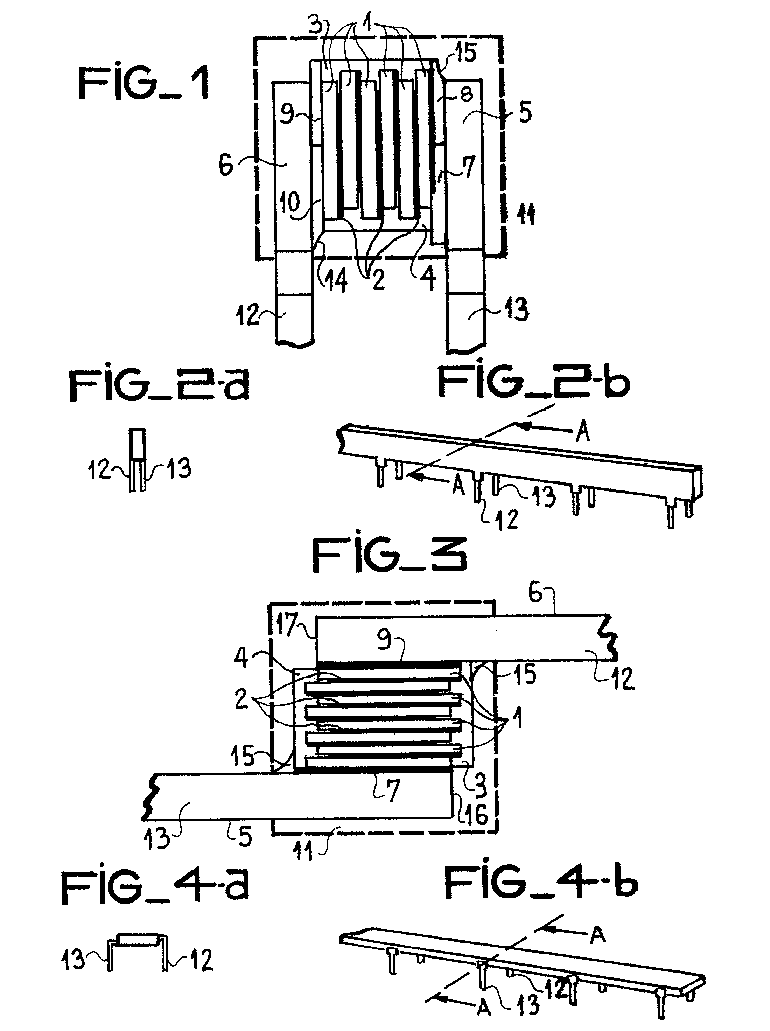

Sur la fig. 1, les films diélectriques 1 recouverts respectivement de couches métalliques 2 sont décalés les uns par rapport aux autres, les couches d'un même rang (pair et impair) étant reliés entre elles par des connexcions électriques latérales telles que 3 et 4. Les barres conductrices 5 et 6 sont assemblées de part et d'autre de l'empilement des films diélectriques métallisés à l'aide de couches adhésives isolantes, telles que 7 et 9, et de couches adhésives conductrices telles que 8 et 10. On remarque sur cette figure que, pour assurer un meilleur contact électrique entre les connexions électriques latérales 3 et 4 et les couches adhésives 8 et 10, celles-ci se terminent par des ménisques 14 et 15 qui correspondent au remplissage des dièdres rentrants formés par les connexions électriques latérales 3 et 4 et les barres d'alimentation 5 et 6.

Sur cette figure, l'ensemble de la barre conductrice, excepté les pattes de connexion 12 et 13, a été noyé dans une résine 11 dont le pourtour est représenté en pointillé sur la figure.

Sur la fig. 2 est représentée une barre d'alimentation sensiblement à l'échelle 1. Sur la fig. 2a, cette barre est vue de face avec ces ensembles de pattes de connexion 12 et 13, tandis que la fig. 2b représente une coupe selon AA de la fig. 2a. La configuration de la barre représentée sur les fig. 1 et 2 correspondant à la configuration dite verticale de ladite barre.

Sur la fig. 3 est représentée une deuxième variante de réalisation des barres d'alimentation selon l'invention, correspondant à la configuration dite horizontale. Sur cette figure, les mêmes éléments que ceux des figures précédentes portent les mêmes références. Par rapport à la fig. 1, la seule différence sur cette fig. 3 est constituée par la disposition des barres conductrices 5 et 6. Ces barres conductrices ont leurs pattes de connexions respectives 12 et 13 situées du même côté que les connexions électriques latérales 3 et 4 auxquelles elles sont respectivement reliées. Dans cette configuration, on peut, sans que cela soit nécessaire, éviter l'utilisation de colles isolantes. Dans ce cas, il suffit de raccorder les barres conductrices selon la configuration représentée sur la figure, en prenant soin d'éviter le contact électrique entre les barres et les connexions électriques latérales 3 et 4. Dans ce but, les parties supérieures 16 et 17 des barres conductrices sont situées approximativement à la même hauteur que les tranches de films diélectriques métallisés auxquelles elles sont reliées.

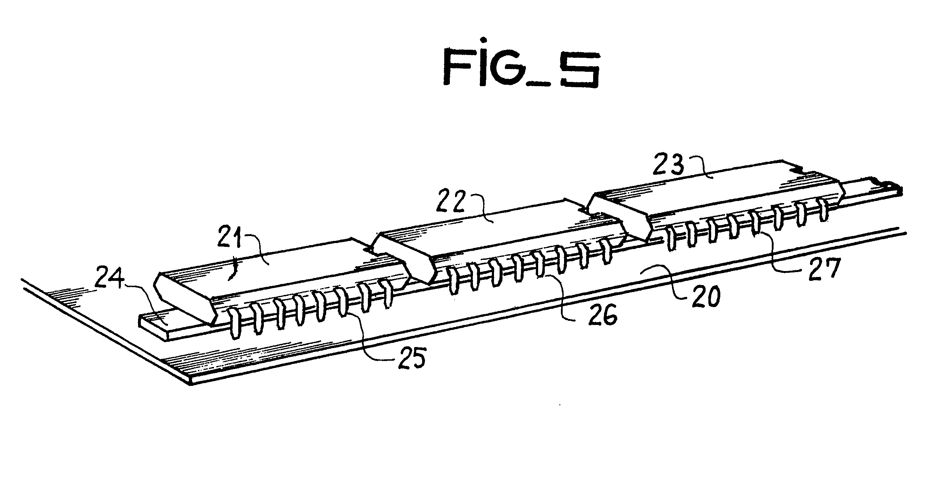

Sur la fig. 4a est représentée une vue à l'échelle 1 environ d'unee barre d'alimentation telle que décrite sur la fig. 3. Cette barre d'alimentation est de forme très plate, ce qui permet de l'utiliser en particulier, comme cela est montré sur la fig. 5, pour alimenter des circuits intégrés tels que 21, 22, 23 disposés sur une carte imprimée 20. Dans une telle configuration, la barre d'alimentation 24, conforme à celle décrite sur les fig. 3 et 4, peut venir se loger entre les pattes de connexion telles que 25, 26 et 27 desdits circuits intégrés. Une telle disposition est rendue facilement réalisable par la structure des barres selon l'invention.

*Exemple:*

Un film de polytéréphtalate d'éthylène, de constante diélectrique relative 3,2, est revêtu d'une couche d'aluminium déposée sous vide d'épaisseur sensiblement égale à 200 Å, représentant une résistance carrée d'environ 1,5 $\Omega$. Ce film est découpé en bandelettes de 5 mm de largeur environ. Sur chacune de ces bandelettes, une petite marge a été réalisée par suppression de la couche métallique sur l'un des côtés. On réalise ensuite l'empilement des films métallisés selon la technique décrite dans le brevet français FR-A N° 903040, puis l'on réalise les connexions électriques latérales par projection de métal. Après refroidissement, on découpe les empilements ainsi réalisés en morceaux d'environ 20 cm de longueur. Deux barres métalliques en cuivre possédant des pattes de connexion latérales régulièrement espacées sur leur longueur, et préalablement étamées, sont ensuite assemblées avec l'empilement réalisé ci-dessus. Pour réaliser cet assemblage, les barres métalliques sont recouvertes par sérigraphie d'une colle époxy conductrice à un composant comportant 60% d'argent pur. Après séchage et polymérisation de la colle, la barre d'alimentation est ensuite soumise à l'opération de marquage et est prête à l'emploi.

Des mesures électriques effectuées sur cette barre ont permis d'obtenir les résultats suivants.

— Résistance d'isolement sous 10 V: 75 000 MΩ (mesure effectuée selon la norme NFC 93 050, article 1).

— Capacité de la barre mesurant 23 cm de longueur: 690 nF.

— Tension de tenue (selon la norme NFC 93 050, article 2): on applique une tension de 100 V entre les deux barres conductrices par l'intermédiaire des connexions, pendant 1 min; sur six échantillons soumis à cet essai, on ne constate aucune perforation diélectrique, ni phénomène d'effluve, ni crépitement, pendant toute la durée de l'essai. Autrement dit, aucun défaut n'est apparu au cours de cet essai. La résistance d'isolement après cet essai reste généralement sensiblement égale à celle de l'échantillon avant essai.

La mesure de la résistance par unité de longueur de la barre d'alimentation selon l'invention se situe pour les six échantillons précédemment utilisés entre 0,21 et 0,22 mΩ/cm. Le cuivre utilisé ayant une résistivité de 0,017 Ω/mm²/mm, la résistance théorique de ces barres est égale à 0,21 mΩ/cm. Il est donc tout à fait remarquable que les barres d'alimentation selon l'invention n'apportent pas de perturbations dans la valeur de la résistance des barres conductrices utilisées.

Enfin, l'impédance caractéristique des barres mesurées à l'aide d'un générateur d'impulsions, avec un temps de montée inférieur à 5 ns, a permis de trouver une impédance caractéristique moyenne sur les six échantillons mentionnés ci-dessus égale à 0,31 Ω, la valeur calculée théorique correspondante étant de 0,22 Ω.

On constate donc que les lignes ainsi réalisées ont une très faible impédance caractéristique, que leur procédé de réalisation apporte très peu de pertes (l'impédance caractéristique mesurée est peu différente de l'impédance caractéristique théorique).

A titre comparatif, l'impédance caractéristique de produits du même type couramment disponibles dans le commerce a été trouvée voisine de 2,5 Ω.

Dans l'exposé qui précède, on a généralement utilisé le terme de barre d'alimentation (ou bus-bar selon l'application anglo-saxonne). Il est bien évident que ce terme ne limite en aucune façon la fonction de ces barres à un moyen de connexion d'une source de tension d'alimentation à une pluralité de circuits. Il désigne au contraire un moyen de connexion d'un générateur (source) quelconque de signal électrique continu ou alternatif, analogique ou numérique, à un récepteur quelconque utilisant ce signal.

## Revendications

1. Barre d'alimentation de faible impédance caractéristique pour la transmission d'un signal électrique d'une source à une pluralité de récepteurs, ladite barre d'alimentation comportant notamment deux barres conductrices véhiculant le signal, séparées par des moyens diélectriques, caractérisée en ce que les moyens diélectriques sont constitués par un empilement de films diélectriques métallisés formant un ensemble de 3 n films diélectriques (1), identiques ou différents, disposés en alternance avec 2 n couches métalliques (2), les couches métalliques de rangs pair et impair étant respectivement reliées entre elles latéralement par des connexions électriques (3, 4), les barres conductrices (5, 6) étant fixées de part et d'autre de l'empilement et reliées électriquement, respectivement, à l'une des connexions électriques latérales (3, 4).

2. Barre d'alimentation selon la revendication 1, caractérisée en ce que l'empilement comporte des films diélectriques métallisés sur une face.

3. Barre d'alimentation selon l'une des revendications 1 ou 2, caractérisée en ce que l'empilement comporte des films diélectriques métallisés sur les deux faces.

4. Barre d'alimentation selon l'une des revendications 1 à 3, caractérisée en ce que les barres conductrices et les empilements sont séparés par des moyens formant coussin (7, 8, 9, 10).

5. Barre d'alimentation selon la revendication 4, caractérisée en ce que les moyens formant coussin (7, 8, 9, 10) ont une épaisseur supérieure ou égale à 10 μm.

6. Barre d'alimentation selon l'une des revendications 4 ou 5, caractérisée en ce que les moyens formant coussin sont constitués par un adhésif.

7. Barre d'alimentation selon la revendication 5, caractérisée en ce que l'adhésif situé à proximité de la connexion électrique à laquelle la barre conductrice est reliée est un adhésif électriquement conducteur (8, 10) tandis que celui situé à proximité de l'autre connexion électrique est isolant (7, 9).

8. Barre d'alimentation selon l'une des revendications 4 ou 5, caractérisée en ce que les moyens formant coussin sont constitués par au moins une couche électriquement inactive.

9. Barre d'alimentation selon la revendication 8, caractérisée en ce que l'une au moins des couches électriquement inactives est constituée par un film diélectrique souple, identique ou différent de l'un des films diélectriques constituant l'empilement.

10. Barre d'alimentation selon la revendication 9, caractérisée en ce que ledit film diélectrique souple est rendu solidaire des films constituant l'empilement par les connexions électriques latérales (3, 4).

11. Barre d'alimentation selon l'une des revendications précédentes, caractérisée en ce que l'empilement de films diélectriques métallisés comporte également m couches d'adhésif disposées entre les 2 n couches de films diélectriques métallisés, avec $1 \leqslant m \leqslant 2 n - 1$.

12. Barre d'alimentation selon la revendication 11, caractérisée en ce que l'épaisseur d'adhésif est comprise entre 0,2 et 2 μm.

13. Barre d'alimentation selon l'une des revendications 1 à 12, caractérisée en ce que les barres conductrices sont munies, sur l'un de leur bord, de pattes de connexions (12, 13) régulièrement réparties sur toute leur longueur.

14. Barre d'alimentation selon l'une des revendications 1 à 13, caractérisée en ce que le film diélectrique est choisi parmi le papier, les polyesters, les polyoléfines, le polycarbonate, le polysulfone, les polyamides, les polyimides, les polyamides-imides, le polytétrafluoroéthylène et le polyfluorure de vinylidène.

15. Barre d'alimentation selon l'une des revendications 1 à 14, caractérisée en ce que les couches métalliques sont constituées d'un métal choisi parmi l'aluminium, le zinc, l'argent, l'or et le cuivre.

16. Barre d'alimentation selon l'une des revendications 1 à 15, caractérisée en ce que le nombre de couches de films diélectriques est compris entre quatre et vingt, l'épaisseur de la barre étant inférieur à 3 mm.

## Patentansprüche

1. Sammelschiene mit niedriger charakteristischer Impedanz für die Übertragung eines elektrischen Signals an eine Vielzahl von Empfängern, wobei die Sammelschiene insbesondere zwei leitende Schiene aufweist, über die das Signal läuft und die durch dielektrische Mittel voneinander getrennt sind, dadurch gekennzeichnet, dass die dielektrischen Mittel von einem Stapel metallisierter dielektrischer Folien gebildet werden, der also aus 2n gleichen oder unterschiedlichen dielektrischen Folien (1) und abweschelnd damit 2n Metallschichten (2) gebildet wird, wobei die Metallschichten geradzahligen bzw. ungeradzahligen Rangs je miteinander seitlich über elektrische Verbindungen (3, 4) verbunden sind und die leitenden Schienen (5, 6) auf dem Stapel zu dessen beiden Seiten befestigt sind und je an eine der seitlichen elektrischen Verbindungen (3, 4) angeschlossen sind.

2. Sammelschiene nach Anspruch 1, dadurch gekennzeichnet, dass der Stapel dielektrische Folien enthält, die auf einer Seite metallisiert sind.

3. Sammelschiene nach einem der Ansprüche 1 oder 2, dadurch gekennzeichnet, dass der Stapel dielektrische Folien enthält, die auf beiden Seiten metallisiert sind.

4. Sammelschiene nach einem der Ansprüche 1 bis 3, dadurch gekennzeichnet, dass die leitenden Schienen und die Stapel durch Mittel voneinander getrennt sind, die ein Kissen (7, 8, 9, 10) bilden.

5. Sammelschiene nach Anspruch 4, dadurch gekennzeichnet, dass die ein Kissen (7, 8, 9, 10) bildenden Mittel eine Dicke aufweisen, die grösser oder gleich 10 μm ist.

6. Sammelschiene nach einem der Ansprüche 4 oder 5, dadurch gekennzeichnet, dass die ein Kissen bildenden Mittel aus einem Kleber bestehen.

7. Sammelschiene nach Anspruch 6, dadurch gekennzeichnet, dass der Kleber, der sich in der Nähe der elektrischen Verbindung befindet, and die die leitende Schiene angeschlossen ist, als elektrisch leitender Kleber (8, 10) ausgebildet ist, während der Kleber, der sich in der Nähe der anderen elektrischen Verbindung befindet, ein isolierender Kleber (7, 9) ist.

8. Sammelschiene nach einem der Ansprüche 4 oder 5, dadurch gekennzeichnet, dass die ein Kissen bildenden Mittel aus mindestens einer Schicht aus einem elektrisch inaktiven Material bestehen.

9. Sammelschiene nach Anspruch 8, dadurch gekennzeichnet, dass mindestens eine der aus einem elektrisch inaktiven Material bestehenden Schichten von einer biegsamen dielektrischen Folie gebildet wird, die einer der dielektrischen des Stapels gleicht oder nicht.

10. Sammelschiene nach Anspruch 9, dadurch gekennzeichnet, dass die biegsame dielektrische Folie über die seitlichen elektrischen Verbindungen (3, 4) an den den Stapel bildenden Folien befestigt ist.

11. Sammelschiene nach einem der vorhergehenden Ansprüche, dadurch gekennzeichnet, dass der Stapel von metallisierten dielektrischen Folien ausserdem m Klebeschichten aufweist, die zwischen den 2 n Schichten von metallisierten dielektrischen Folien angeordnet sind, wobei $1 \leqslant m \leqslant 2 n - 1$ ist.

12. Sammelschiene nach Anspruch 11, dadurch gekennzeichnet, dass die Dicke der Klebeschicht zwischen 0,2 und 2 μm liegt.

13. Sammelschiene nach einem der Ansprüche 1 bis 12, dadurch gekennzeichnet, dass die leitenden Schienen an einer ihrer Seitenkanten mit Anschlussfahnen (12, 13) in gleichmässiger Verteilung über die ganze Länge versehen sind.

14. Sammelschiene nach einem der Ansprüche 1 bis 13, dadurch gekennzeichnet, dass die dielektrische Folie aus einem material ist, das aus Papier, den Polyestern, den Polyolefinen, dem Polycarbonat, dem Polysulfon, den Polyamiden, den Polyimiden, den Polyamid-Imiden, dem Polytetrafluoräthylen und dem Vinylidenpolyfluorid ausgewählt ist.

15. Sammelschiene nach einem der Ansprüche 1 bis 14, dadurch gekennzeichnet, dass die Metallschichten aus einem Metall bestehen, das aus Aluminium, Zink, Silber, Gold und Kupfer ausgewählt ist.

16. Sammelschiene nach einem der Ansprüche 1 bis 15, dadurch gekennzeichnet, dass die Anzahl der Schichten dielektrischer Folien zwischen 4 und 20 liegt, wobei die Gesamtdicke der Schiene unter 3 mm bleibt.

## Claims

1. A low characteristic impedance bus-bar for transmitting an electric signal from a source to a plurality of receivers, said bus-bar essentially comprising two conducting bars conveying the signal and separated by dielectric means, characterized in that the dielectric means are formed by a stack of metal-coated dielectric films forming an assembly of $2n$ dielectric films (1), identical or different, alternatively disposed with $2n$ metal layers (2), the metal layers of even and odd rank being respectively interconnected laterally by electric connections (3, 4), the conducting bars (5, 6) being secured on each side of the stack and electrically connected respectively to one of said lateral electric connections (3, 4).

2. A bus-bar as claimed in Claim 1, characterized in that said stack comprises dielectric films which are metal-coated on one face.

3. A bus-bar as claimed in one of Claims 1 or 2, characterized in that said stack comprises dielectric films which are metal-coated on both faces.

4. A bus-bar as claimed in one of Claims 1 to 3, characterized in that said conducting bars and said stacks are separated by cushion-forming means (7, 8, 9, 10).

5. A bus-bar as claimed in Claim 4, characterized in that said cushion-forming means (7, 8, 9, 10) have a thickness greater than or equal to 10 µm.

6. A bus-bar as claimed in one of Claims 4 or 5, characterized in that said cushion-forming means are formed by an adhesive.

7. A bus-bar as claimed in Claim 6, characterized in that the adhesive situated in the vicinity of the electric connection to which the conducting bar is connected is an electrically conducting adhesive (8, 10), whereas that situated in the vicinity of the other electric connection is insulating (7, 9).

8. A bus-bar as claimed in one of Claims 4 or 5, characterized in that said cushion-forming means are made of at least one electrically inactive layer.

9. A bus-bar as claimed in Claim 8, characterized in that one at least of the electrically inactive layers is formed by a flexible dielectric film, identical to or different from one of the dielectric films forming the stack.

10. A bus-bar as claimed in Claim 9, characterized in that said flexible dielectric film is made solid with the films forming the stack by means of the lateral electrical connections (3, 4).

11. A bus-bar as claimed in one of the preceding claims, characterized in that said stack of metal-coated films also comprises $m$ adhesive layers disposed between the $2n$ layers of metal-coated dielectric films, with $1 \leqslant m \leqslant 2n - 1$.

12. A bus-bar as claimed in Claim 11, characterized in that the adhesive thickness is between 0,2 and 2 µm.

13. A bus-bar as claimed in one of Claims 1 to 12, characterized in that said conducting bars are provided, on one of their edges, with connecting lugs (12, 13) evenly spread out over their entire length.

14. A bus-bar as claimed in one of Claims 1 to 13, characterized in that said dielectric film is chosen from paper, polyesters, polyolefines, polycarbonate, polysulfone, polyamides, polyimides, polyamides-imides, polytetrafluorethylene and vinylidene polyfluoride.

15. A bus-bar as claimed in one of Claims 1 to 14, characterized in that said metal layers are formed from a metal chosen from aluminium, zinc, silver, gold and copper.

16. A bus-bar as claimed in one of Claims 1 to 15, characterized in that the number of dielectric film layers is between four and twenty, the total thickness of said bar being less than 3 mm.

0 053 531

FIG_1

FIG_2·a

FIG_2·b

FIG_3

FIG_4·a

FIG_4·b

9

FIG_5

0 053 531